# EUROPEAN PATENT APPLICATION

(11) **EP 1 713 176 A1**
(43) Date of publication of application: **18.10.2006**
(21) Application number: 04708920.6
(22) Date of filing: 06.02.2004
(51) Int. Cl.: H03F 3/24, H03G 3/30

(54) **POWER AMPLIFIER UNIT, COMMUNICATION TERMINAL AND CONTROL METHOD OF POWER AMPLIFIER UNIT**

(71) Applicant: MITSUBISHI DENKI KABUSHIKI KAISHA, Chiyoda-ku, Tokyo 100-8310 (JP)
(72) Inventor: BABA, Makoto, Mitsubishi Denki Kabushiki Kaisha, Tokyo, 100-8310 (JP)
(74) Representative: Popp, Eugen
(86) International application number: PCT/JP2004/001305
(87) International publication number: WO 2005/076467

(57) **Abstract**

The present invention relates to a power amplifier device having a power amplifier, and an object of the invention is to enable efficient use of the power amplifier without causing any problems in the operation of the power amplifier.

In order to achieve the object, a controller block 11 judges on the basis of an estimative output power value whether a power amplifier is in a first period in which it performs low power output operation or in a second period in which it performs high power output operation, where, in the first period, the controller block 11 activates a DC/DC converter 2 to supply a power-supply voltage Vdd2 as the operating power-supply voltage to the HPA 1, and in the second period, the controller block 11 controls the DC/DC converter 2 between active and inactive states and a switch 3 between on and off states on the basis of a detected power-supply voltage value VM obtained from an operating power-supply voltage detecting circuit 13, so as to supply one of the power-supply voltage Vdd2 and a power-supply voltage Vdd3 as the operating power-supply voltage.

## Description

### TECHNICAL FIELD

The present invention relates to a power amplifier device having a power amplifier and controlling the operating power-supply voltage supplied to the power amplifier, a controlling method thereof, and a communication terminal device using the power amplifier device.

### BACKGROUND ART

In a mobile phone (mobile communication terminal) as one of the mobile communication terminal devices, a speech signal input from the microphone is amplified in a power (speech) amplifier, superimposed on a carrier, and sent to a base station. Conventionally, such a power amplifier is supplied with power at its power-supply voltage terminal directly from a rechargeable battery, such as a lithium-ion battery, serving as the power source of the mobile communication terminal.

Japanese Patent Application Laid-Open No. 2002-290247 (hereinafter referred to simply as "Patent Document 1") discloses a power-supply voltage controller device and a mobile communication terminal having the power-supply voltage controller device, where the operating power-supply voltage for the power amplifier is controlled according to transmission power, whereby the efficiency of the power amplifier is enhanced and the dissipation of the rechargeable battery is suppressed so that the rechargeable battery can be used efficiently.

The power-supply voltage controller device disclosed in Patent Document 1 characteristically includes a power-supply voltage table that associates the output power of the power amplifier and the operating power-supply voltage of the power amplifier, and voltage controlling means that controls the power-supply voltage supplied to the power amplifier on the basis of the power-supply voltage table, where a DC/DC converter is used as the voltage controlling means.

However, in the power-supply voltage controller device disclosed in Patent Document 1, the DC/DC converter has relatively large resistance value and therefore causes large voltage drop in high-output operations where the power amplifier outputs power higher than a given level, and then it is difficult to supply sufficient power-supply voltage for the operation of the power amplifier.

### DISCLOSURE OF THE INVENTION

The present invention has been made to solve the problem above, and an object of the present invention is to obtain a power-supply voltage controller device that allows efficient use of a power amplifier without any problems in the operation of the power amplifier.

According to the present invention, a power amplifier device includes: a power amplifier (1) that operates with an operating power-supply voltage obtained from a first power-supply voltage; an operating power-supply voltage detecting circuit (13) that detects one of said operating power-supply voltage and said first power-supply voltage to obtain a detected power-supply voltage value; and an operating power-supply voltage supplying portion (2, 3, 4, 11, 12) that has a power estimation function of estimating an output power value to be outputted from said power amplifier as an estimative output power value and that supplies said power amplifier with said operating power-supply voltage determined on the basis of said estimative output power value and said detected power-supply voltage value.

According to the present invention, a communication terminal device includes: a transmitter block (6) that generates a transmission signal; a power amplifier (1) that is supplied with an operating power-supply voltage obtained from a first power-supply voltage outputted from a battery so as to operate to amplify transmission power of said transmission signal; an operating power-supply voltage detecting circuit (13) that detects one of said operating power-supply voltage and said first power-supply voltage to obtain a detected power-supply voltage value; and an operating power-supply voltage supplying portion (2, 3, 4, 11, 12) that controls said transmitter block and has a power estimation function of estimating an output power value to be outputted from said power amplifier as an estimative output power value, and that supplies said power amplifier with said operating power-supply voltage based on said estimative output power value and said detected power-supply voltage value.

According to the present invention, a method of controlling a power amplifier device having a power amplifier (1) that operates with an operating power-supply voltage obtained from a first power-supply voltage outputted from a battery comprises the steps of: (a) detecting one of said operating power-supply voltage and said first power-supply voltage to obtain a detected power-supply voltage value; (b) estimating an output power value to be outputted from said power amplifier as an estimative output power value and judging whether said power amplifier performs a high power output operation or a low power output operation on the basis of said estimative output power value; (c) when said step (b) judges that said power amplifier performs said low power output operation, supplying a voltage obtained by decreasing said first power-supply voltage as said operating power-supply voltage; and (d) when said step (b) judges that said power amplifier performs said high power output operation, supplying, as said operating power-supply voltage, one of said first power-supply voltage and said voltage obtained by decreasing said first power-supply voltage on the basis of said detected power-supply voltage value.

In accordance with the invention, the power amplifier device controls the operating power-supply voltage supplied to the power ainplifier not only with the estimative output power value but also with the detected power-supply voltage value obtained by detecting the operating power-supply voltage of the power amplifier or the first power-supply voltage, which allows efficient use of the power amplifier without causing any problems in the operation of the power amplifier.

In the communication terminal device of the invention, the operating power-supply voltage supplying portion supplies the power amplifier with an operating power-supply voltage that is determined on the basis of not only the estimative output power value but also the detected power-supply voltage value obtained by detecting the operating power-supply voltage of the power amplifier or the first power-supply voltage outputted from the battery, which allows efficient use of the power amplifier without causing any problems in the operation of the power amplifier.

In accordance with the invention, the power amplifier device control method supplies the power amplifier with an operating power-supply voltage that is determined not only by the control based on the estimative output power value performed in the steps (b) and (c) but also with, in the steps (b) and (d), the detected power-supply voltage value obtained by detecting the operating power-supply voltage of the power amplifier or the first power-supply voltage outputted from the battery, which allows efficient use of the power amplifier without causing any problems in the operation of the power amplifier.

These and other objects, features, aspects and advantages of the present invention will become more apparent from the following detailed description of the present invention when taken in conjunction with the accompanying drawings.

### BRIEF DESCRIPTION OF THE DRAWINGS

FIG. 1 is a block diagram showing the structure of a communication terminal device having a power amplifier device according to a first embodiment of the present invention.
FIG. 2 is an illustrative diagram showing an example of a controlling power-supply voltage/power table stored in the RAM shown in FIG. 1.
FIG. 3 is a flowchart of an operation of determining the operating power-supply voltage that is performed in the power amplifier device of the communication terminal device of the first embodiment.
FIG. 4 is an illustrative diagram showing how a DC/DC converter and a switch are selectively used according to the value of the power-supply voltage of the battery during a high power output operation.
FIG. 5 is an illustrative diagram showing how the recognition of the controlling power-supply voltage/power table is changed when temperature and frequency vary.
FIG. 6 is a block diagram showing the structure of a communication terminal device having a power amplifier device according to a second embodiment of the present invention.
FIG. 7 is a flowchart showing an operation of determining the operating power-supply voltage that is performed by the power amplifier device of the communication terminal device of the second embodiment.

### BEST MODE FOR IMPLEMENTING THE INVENTION

### First Embodiment.

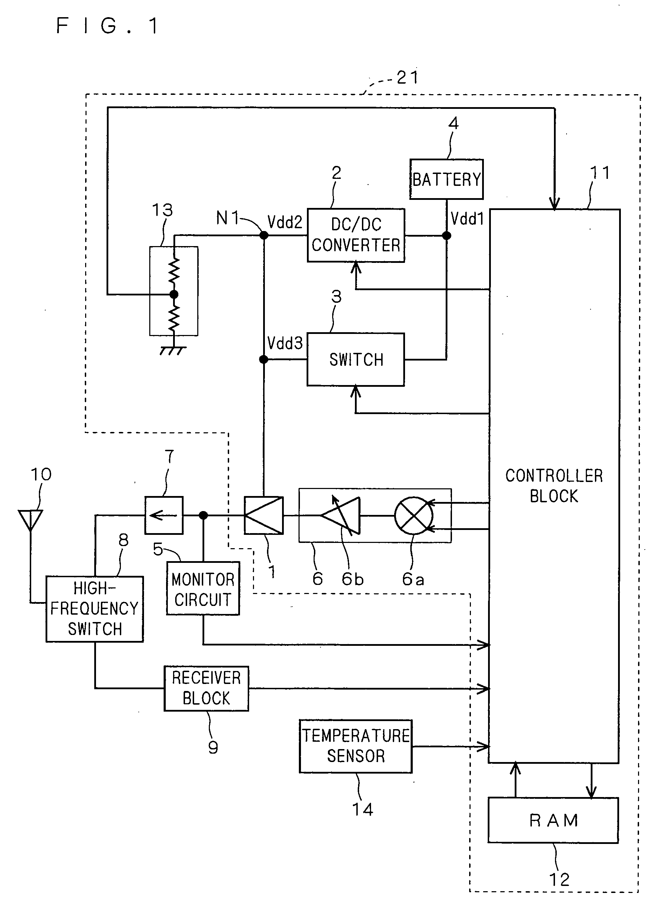

FIG. 1 is a block diagram showing the structure of a communication terminal device, e.g., a mobile phone, that includes a power amplifier device according to a first embodiment of the present invention.

As shown in the diagram, an HPA (High Power Amplifier) 1, serving as a power amplifier, amplifies a high-frequency signal (transmission signal) provided from a transmitter block 6, and sends the obtained amplified high-frequency signal through an isolator 7, a high-frequency switch 8, and an antenna 10. The isolator 7 is provided to reduce power reflected from the antenna 10 to allow stable operation of the HPA 1, and the high-frequency switch 8 is provided to determine the signal route from the transmitter block 6 to the antenna 10 during transmission and the signal route from the antenna 10 to the receiver block 9 during reception. The high-frequency switch 8 functions also as a duplexer to block the signal coming along the route from the transmitter block 6 to the receiver block 9.

The transmitter block 6 includes a multiplier 6a and a variable gain amplifier 6b, where the multiplier 6a applies frequency conversion to a baseband signal to frequency-convert it to a high-frequency signal. Then, the variable gain amplifier 6b amplifies the high-frequency signal to generate a transmission signal. The gain of the variable gain amplifier 6b varies on the basis of the value of a gain controlling voltage specified by a controller block 11 that is formed of, e.g., a microcomputer.

On the other hand, during reception, the receiver block 9 receives a high-frequency signal through the antenna 10 and the high-frequency switch 8, and performs frequency conversion to convert the high-frequency signal to a baseband signal. The controller block 11 then captures the frequency-converted baseband signal as a received signal. The received signal includes instructions that define the transmission power and transmission frequency.

The HPA 1 is supplied with, as its operating power-supply voltage, a power-supply voltage Vdd2 (a second power-supply voltage) obtained through a DC/DC converter 2 serving as a power-supply voltage converting portion, or a power-supply voltage Vdd3 (a third power-supply voltage) obtained through a switch 3 (a switch portion). The DC/DC converter 2 is controlled between active and inactive states by the controller block 11. In the active state, the DC/DC converter 2 receives a power-supply voltage Vdd1 (a first power-supply voltage) outputted from a battery 4 serving as a power-supply voltage source and drops it to the power-supply voltage Vdd2, which is supplied as the operating power-supply voltage to the HPA 1. The DC/DC converter 2 operates such that the power-supply voltage Vdd2 agrees with a controlling power-supply voltage value TVc indicated by the controller block 11.

On the other hand, when the switch 3, formed of FET, for example, is turned on under the control by the controller block 11, the switch 3 supplies the power-supply voltage Vdd1 from the battery 4 to the HPA 1 as the power-supply voltage Vdd3. The power-supply voltage Vdd3 is nearly equal to the power-supply voltage Vdd1, but, when the switch 3 is formed of FET, for example, the power-supply voltage Vdd3 is lower than the power-supply voltage Vdd1 by the threshold voltage of the FET.

A monitor circuit 5 monitors the output power of the HPA 1 and outputs the obtained monitored power value to the controller block 11. The monitored power value is for confirmation, and is not related at all to the operation of controlling the operating power-supply voltage of the HPA 1 that is conducted under the control by the controller block 11. For example, the monitor circuit 5 is made of circuitry that extracts part of the output power of the HPA 1 from a portion of its current output route and converts the power to voltage.

A temperature sensor 14 is provided in a given position of the mobile terminal device, and measures the device temperature of the mobile terminal device and outputs the measured temperature to the controller block 11.

An operating power-supply voltage detecting circuit 13 detects the operating power-supply voltage by detecting voltage obtained from a node N1 as the input node of the operating power-supply voltage to the HPA 1 (the output node of the DC/DC converter 2 and the switch 3), and it outputs the detected result as a detected power-supply voltage value VM to the controller block 11.

A RAM 12 stores a controlling power-supply voltage/power table T12 in which the gain controlling voltage for the variable gain amplifier 6b and the operating power-supply voltage for the HPA 1 are associated with adjusted estimative transmission power in the form of a table. The adjusted estimative transmission power means transmission power values that were adjusted on the manufacturing line during the manufacture of the communication terminal device.

The controller block 11 forms a power amplifier device 21 together with the HPA 1, DC/DC converter 2, switch 3, battery 4, transmitter block 6, RAM 12, and operating power-supply voltage detecting circuit 13, and provides various control operations as will be described later, such as control of the operating power-supply voltage of the HPA 1, control of the transmitter block 6, and so on. The portion of the power amplifier device 21 excluding the HPA 1, transmitter block 6, and operating power-supply voltage detecting circuit 13 functions as a power-supply voltage supplying portion.

The controller block 11 has a power estimation function to estimate "estimative transmission power", which will be fully described later. On the basis of the estimative transmission power, the controller block 11 judges whether the power amplifier is in a first period where it performs a low power output operation or in a second period where it performs a high power output operation.

In the first period, the controller block 11 places the DC/DC converter 2 in an active state to supply the power-supply voltage Vdd2 as the operating power-supply voltage. On the other hand, in the second period, the controller block 11 controls the DC/DC converter 2 between the active and inactive states and the switch 3 between on and off according to the detected power-supply voltage value VM, whereby one of the power-supply voltage Vdd2 and the power-supply voltage Vdd3 is supplied as the operating power-supply voltage.

The operating power-supply voltage detecting circuit 13 is formed of resistance voltage division (resistance value division) circuitry, for example. When the power-supply voltage Vdd4=4V and the resistance value for the resistance voltage division=20 kΩ, for example, then the current consumed in the operating power-supply voltage detecting circuit 13 is equal to 4/(20,000*2)=0.1 mA. On the other hand, the current reduced by the power amplifier device 21 is of the order of several tens mA, and so the current consumed in the operating power-supply voltage detecting circuit 13 does not adversely affect the power amplifier device 21.

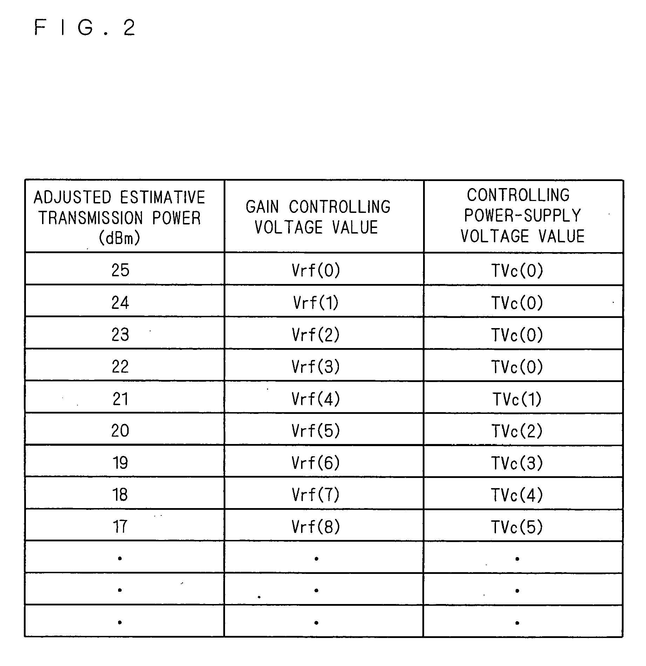

FIG. 2 is an illustrative diagram showing an example of the controlling power-supply voltage/power table. As shown in the diagram, the values of the gain controlling voltage Vrf(i) (i=0, ..., 8, ...), for controlling the gain of the variable gain amplifier 6b, and the values of the controlling power-supply voltage TVc(i) are defined in association with the values of the adjusted estimative transmission power. The values of the gain controlling voltage Vrf have a relation of Vrf(i)>Vrf(i+j) (j≥1), and the values of the controlling power-supply voltage TVc have a relation of TVc(i)>TVc(i+j), where the controlling power-supply voltage TVc is set at its maximum value TVc(0) when the adjusted estimative transmission power is 22 dBm or higher, for example. Referring to the controlling power-supply voltage/power table T12, when the estimative transmission power is 20 dBm, for example, it can be realized by setting the gain controlling voltage value Vrf(5) for the variable gain amplifier 6b and the controlling power-supply voltage value TVc(2) in the adjusted condition.

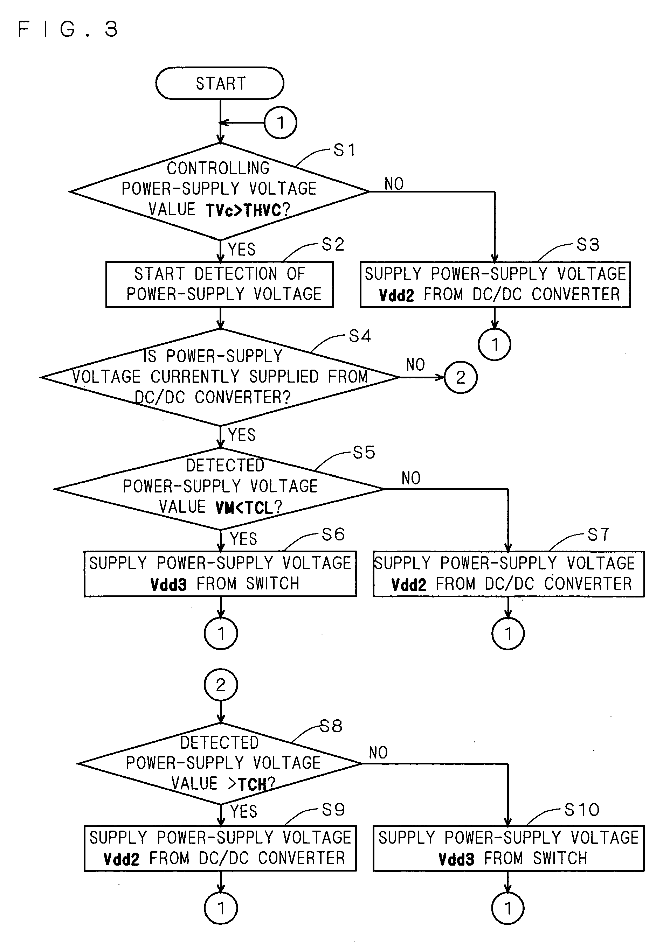

FIG. 3 is a flowchart showing how the operating power-supply voltage is supplied to the HPA 1 under the control by the controller block 11 in the power amplifier device 21 of the communication terminal device of the first embodiment. The procedure will now be described referring to the diagram. Though not shown in FIG. 3, the supply of the power-supply voltage Vdd2 by the DC/DC converter 2 is set in the initial state immediately after the beginning of a transmission operation. Alternatively, the supply of the power-supply voltage Vdd3 by the switch 3 may be set in the initial state.

First, in step S1, the value of the controlling power-supply voltage TVc to be given to the DC/DC converter 2, which can vary from moment to moment, is compared with a given reference voltage THVC, and when TVc>THVC, the process judges that the HPA 1 is in a high (power) output period (the second period) and moves to step S2. In the other case, the process judges that the HPA 1 is in a low (power) output period (the first period) and moves to step S3.

The controller block 11 determines the value of the controlling power-supply voltage TVc as below. The controller block 11 has a power estimation function, where, on the basis of transmission power defined in an instruction contained in the received signal, the controller block 11 estimates the estimative transmission power that corresponds to estimative output power value to be outputted from the HPA 1. Accordingly, the value of the estimative transmission power varies from moment to moment as the instruction defining the transmission power varies.

The controller block 11 refers to the controlling power-supply voltage/power table T12 stored in the RAM 12, and determines that the controlling power-supply voltage value TVc(i) that corresponds to the adjusted estimative transmission power that agrees with the above-mentioned estimative transmission power is the controlling power-supply voltage value TVc used in step S1. For example, when the estimative output power value is 20 dBm, the controller block 11 determines that the controlling power-supply voltage value TVc used in step S1 is TVc(2).

It is thus possible to correctly recognize whether the output state of the HPA 1 is the high voltage output state or the low voltage output state on the basis of the controlling power-supply voltage value TVc corresponding to the estimative transmission power by referring to the controlling power-supply voltage/power table T12.

In this way, in estimating the output power value of the HPA 1 (transmission power), the controller block 11 does not utilize the monitored results about the output power of the HPA 1 obtained by the monitor circuit 5, and therefore the monitor circuit 5, used merely for confirmation, does not require achievement of high precision (large dynamic range).

In step S3 that is performed when TVc<THVC (the first period) in step S1, the process judges that the HPA 1 is presenting low power output and activates the DC/DC converter 2 and turns off the switch 3 so that the power-supply voltage Vdd2 is supplied as the operating power-supply voltage through the DC/DC converter 2. In this case, the DC/DC converter 2 is controlled such that the power-supply voltage Vdd2 agrees with the controlling power-supply voltage value TVc. After step S3, the flow returns to step S1. After that, the operations of steps S 1 and S3 are repeated until TVc becomes larger than THVC (TVc>THVC).

In step S2 that is performed when TVc>THVC (the second period) in step S1, the operating power-supply voltage detecting circuit 13 starts detecting the operating power-supply voltage at the node N1 and obtains the detected power-supply voltage value VM. Accordingly, the obtained detected power-supply voltage value VM is the measurement of the power-supply voltage Vdd2 when the DC/DC converter 2 is in the active state, and it is the measurement of the power-supply voltage Vdd3 when the switch 3 is on.

Next, in step S4, the flow checks whether the current supply of the power-supply voltage is from the DC/DC converter 2. When the DC/DC converter 2 is supplying the power-supply voltage, the flow moves to step S5, and when not so (i.e., when the switch 3 is supplying the power-supply voltage), the flow moves to step S8.

When step S4 judges that the current supply of the power-supply voltage is from the DC/DC converter 2, the flow moves to step S5 where the detected power-supply voltage value VM is compared with a reference voltage TCL (a first threshold), and when VM<TCL, then the process judges that the power-supply voltage Vdd2 is too low as the operating power-supply voltage of the HPA1 and moves to step S6. When not so, the process judges that the power-supply voltage Vdd2 is sufficient as the operating power-supply voltage and moves to step S7. In this way, the reference voltage TCL functions as a reference voltage about the power-supply voltage Vdd2 supplied from the DC/DC converter 2. The reference voltage TCL can be a lowest voltage that the HPA 1 requires as its power-supply voltage, for example.

In step S6, the DC/DC converter 2 is made inactive and the switch 3 is turned on to switch to the power-supply voltage Vdd3 supplied from the switch 3. After step S6, the flow returns to step S1.

On the other hand, in step S7, the supply of the power-supply voltage Vdd2 from the DC/DC converter 2 is maintained in the same way as in step S3. The flow moves to step S1 after step S7.

In this way, when the DC/DC converter 2 is supplying the power-supply voltage Vdd2 and VM(=Vdd2)≥VCL, the power-supply voltage Vdd2 is judged to be sufficient as the operating power-supply voltage of the HPA 1 and the supply of the power-supply voltage Vdd2 from the DC/DC converter 2 is maintained. On the other hand, when VM(=Vdd2)<VCL, the power-supply voltage Vdd2 is judged to be insufficient as the operating power-supply voltage of the HPA 1 and the supply is switched to the power-supply voltage Vdd3 supplied from the switch 3.

Thus, even when the HPA 1 is in a high power output period (the second period), the supply of the power-supply voltage Vdd2 from the DC/DC converter 2 is maintained as long as there is no problem for the operation of the HPA 1, which allows efficient operation of the HPA 1.

On the other hand, when step S4 judges that the power-supply voltage is currently being supplied from the switch 3, the flow moves to step S8 where the detected power-supply voltage value VM(=Vdd3) is compared with a reference voltage TCH (>TCL) as a second threshold, and when VM>TCH, the flow judges that the power-supply voltage Vdd3 is excessive and wasteful as the operating power-supply voltage and moves to step S9. When not so, the flow judges that the power-supply voltage Vdd3 is appropriate as the operating power-supply voltage and moves to step S10. Thus, the reference voltage TCH functions as a reference voltage about the power-supply voltage Vdd3 supplied from the switch 3. The reference voltage TCH can be "the initial voltage of the battery 4 (charged voltage when the battery 4 is a rechargeable battery) - α (some margin like a voltage drop caused through the switch 3)", for example.

When an excessive operating power-supply voltage is supplied to the HPA 1, the excessive voltage causes heat generation in the HPA 1. Since the mobile communication terminal devices like portable phones are in progress toward further size reduction and higher density integration, the problem of temperature rise caused by heat generation is not negligible, and efficiently operating the HPA 1 is important also in this aspect. In particular, when a call (transmission) is made during the charging of the battery 4 of the mobile communication terminal device, it is possible to alleviate heat generation in the HPA 1 to reduce the amount of generated heat by about 100 mW, for example.

In step S9, the supply of voltage is switched to the power-supply voltage Vdd2 provided from the DC/DC converter 2 in the same way as in steps S3 and S7. The flow returns to step S 1 after step S9.

In step S 10, the supply of the power-supply voltage Vdd3 from the switch 3 is maintained in the same way as in step S6. The flow returns to step S1 after step S10.

In this way, when the power-supply voltage Vdd3 is being supplied from the switch 3 and VM(=Vdd3)≤VCH, the power-supply voltage Vdd3 is judged to be appropriate as the operating power-supply voltage of the HPA 1, and the supply of the power-supply voltage Vdd3 from the switch 3 is maintained. On the other hand, when VM(=Vdd3)>VCH, the power-supply voltage Vdd3 is judged to be excessive as the operating power-supply voltage of the HPA 1 and the voltage supply is switched to the power-supply voltage Vdd2 supplied from the DC/DC converter 2.

Thus, even when the HPA 1 is in a high power output period (the second period) and the power-supply voltage Vdd3 is being supplied from the switch 3, the voltage supply can be quickly switched to the power-supply voltage Vdd2 supplied from the DC/DC converter 2 if the power-supply voltage Vdd3 is judged to be fully high and the power-supply voltage Vdd2 can be used as the operating power-supply voltage of the HPA 1 without any problems for the operation of the HPA 1, which allows efficient operation of the HPA 1.

Thus, the controlling block 11 controls the operating power-supply voltage of the HPA 1 as below on the basis of the value of the controlling power-supply voltage TVc and the value of the detected power-supply voltage VM, whereby the HPA 1 efficiently operates without any problems.

### (1) When TVc≤THVC is satisfied.

The power-supply voltage Vdd2 is supplied from the DC/DC converter 2 (it is judged that the HPA 1 is in a low power output period and the power-supply voltage Vdd2 is sufficient as its operating power-supply voltage).

### (2) When TVc>THVC is satisfied.

(2-1) VM>TCH ... The power-supply voltage Vdd2 is supplied from the DC/DC converter 2 (it is judged that a sufficient operating power-supply voltage can be obtained even when the supply is switched from the power-supply voltage Vdd3 to the power-supply voltage Vdd2).
(2-2) VM<TCL ... The power-supply voltage Vdd3 is supplied from the switch 3 (it is judged that the power-supply voltage Vdd2 is insufficient as the operating power-supply voltage).
(2-3) TCL≤VM≤TCH ... The current supply of power-supply voltage is maintained (it is judged that maintaining the currently supplied power-supply voltage is the best).

In this way, the operating power-supply voltage itself is detected and the detected power-supply voltage value is compared with two different thresholds (TCL and TCH) respectively in two different states (when the operating power-supply voltage is the power-supply voltage Vdd2 and when it is the power-supply voltage Vdd3), whereby a suitable operating power-supply voltage can be supplied to the HPA 1 in both of the two states.

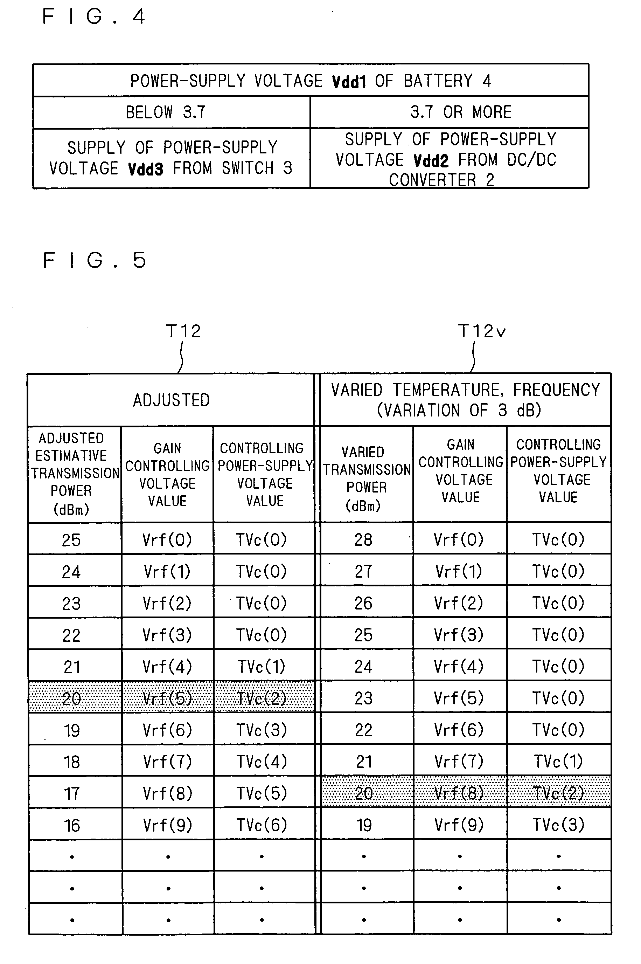

FIG. 4 is an illustrative diagram showing how the DC/DC converter 2 and the switch 3 are selectively used with the power-supply voltage Vdd4 of the battery 4 in a high power output period. In the diagram, it is assumed that, when the battery 4 is a rechargeable battery such as a lithium-ion battery, the power-supply voltage Vdd4 is initially 4.3 V and can be lowered to around 3.1 V during use because of variations occurring with time. It is also assumed that the DC/DC converter 2 operates without any problems when supplied with an operating power-supply voltage of at least 3.5 V.

As shown in FIG. 4, when the power-supply voltage Vdd4 is 3.7 V or higher, supplying the power-supply voltage Vdd2 from the DC/DC converter 2 as the operating power-supply voltage of the HPA 1 allows the HPA 1 to operate normally and more efficiently, and also avoids the above-described problem of heat generation.

On the other hand, when the power-supply voltage Vdd4 is below 3.7 V, supplying the power-supply voltage Vdd3 from the switch 3 as the operating power-supply voltage of the HPA 1 more certainly ensures normal operation of the HPA 1.

In this way, in the high power output period, one of the DC/DC converter 2 and the switch 3 is selected on the basis of the detected power-supply voltage value VM, whereby an appropriate operating power-supply voltage can be supplied to the HPA 1 as the power-supply voltage Vdd4 of the battery 4 varies with time.

FIG. 5 is an illustrative diagram showing how the recognition of the controlling power-supply voltage/power table T12 is varied when temperature and frequency vary.

The relation indicated by the controlling power-supply voltage/power table T12 associates the gain controlling voltage value Vrf and the adjusted estimative transmission power at reference device temperature and reference transmission frequency. That is, the controlling power-supply voltage/power table T12 has a function also as a gain controlling table for the variable gain amplifier 6b.

Accordingly, the relation varies when at least one of the device temperature (the temperature of the communication terminal) and the transmission frequency varies from the reference (reference device temperature or reference transmission frequency). Specifically, the relation between device temperature and transmission power and the relation between transmission frequency and transmission power both have a negative correlation.

On the other hand, the HPA 1 performs the power amplification operation at a fixed amplification ratio, and the transmission power is determined on the basis of the given amplification ratio of the HPA 1 and the gain of the variable gain amplifier 6b. Accordingly, when the relation between the transmission power and the device temperature or transmission frequency has varied, it is then necessary to change the value of the gain controlling voltage of the variable gain amplifier 6 that corresponds to the estimative transmission power.

In the example of FIG. 5, when the device temperature or transmission frequency decreases, the transmission power increases 3 dB when the gain of the variable gain amplifier 6b is controlled still with a controlling power value Vrf obtained from the controlling power-supply voltage/power table T12 of FIG. 2.

In this case, when obtaining the recognition, the controller block 11 replaces the controlling power-supply voltage/power table T12 with an assumed controlling power-supply voltage/power table T12v where the gain controlling voltage value Vrf is modified downward for 3 dB.

In the example of FIG. 5, the gain controlling voltage value Vrf(5), which corresponds to the adjusted estimative transmission power of 20 dBm in the controlling power-supply voltage/power table T12, is modified downward by 3 dB to the gain controlling voltage value Vrf(8) in the assumed controlling power-supply voltage/power table T12v (the gain controlling voltage value Vrf(8) corresponds to the adjusted transmission power of 17 dBm). The controlling power-supply voltage value TVc is not varied but maintained at the controlling power-supply voltage value TVc(2). The controller block 11 automatically changes the recognition from the controlling power-supply voltage/power table T12 to the assumed controlling power-supply voltage/power table T12v on the basis of the device temperature and transmission frequency.

In this way, when referring to the controlling power-supply voltage/power table T12, the controller block 11 recognizes the value of the gain controlling voltage Vrf according to contents based on a difference between device temperature and reference device temperature (according to the correspondence shown in the assumed controlling power-supply voltage/power table T12v), or according to contents based on a difference between transmission frequency and reference transmission frequency.

It is thus possible to make transmission constantly at stable transmission power even when the device temperature of the mobile terminal device and transmission frequency vary from the reference device temperature and transmission frequency in the adjustment condition.

The controller block 11 recognizes the device temperature on the basis of temperature measured by the temperature sensor 14. The transmission frequency is recognized as below. Instructions from a base station are received as a received signal through the route of antenna 10, high-frequency switch 8, and receiver block 9, and the controller block 11 controls the transmitter block 6 to make transmission at the transmission frequency and transmission power defined by the instructions. The controller block 11 therefore always recognizes the transmission frequency.

The controller block 11 thus alters the contents of recognition of the controlling power-supply voltage/power table T12 on the basis of a difference between device temperature and reference device temperature or a difference between transmission frequency and reference transmission frequency, whereby the controller block 11 is capable of controlling the gain of the variable gain amplifier 6b of the transmitter block 6 always with an appropriate value of gain controlling voltage Vrf, and hence capable of making transmission always with stable transmission power.

In addition, because the value of the gain controlling voltage Vrf for the variable gain amplifier 6b is varied in accordance with variations of device temperature or transmission frequency so that the value of the controlling power-supply voltage TVc is not affected, the power amplifier device 21 is capable of precisely controlling the power-supply voltage of the HPA 1 (using the controlling power-supply voltage value TVc) even when the device temperature or transmission frequency varies.

In the first embodiment, the operating power-supply voltage detecting circuit 13 detects the operating power-supply voltage by measuring the voltage at the node N1 corresponding to the power-supply voltage input terminal of the HPA 1, and so the DC/DC converter 2 is kept inactive and the switch 3 is kept off except for during transmission, whereby the operating power-supply voltage detecting circuit 13 consumes no wasteful current.

### Second Embodiment.

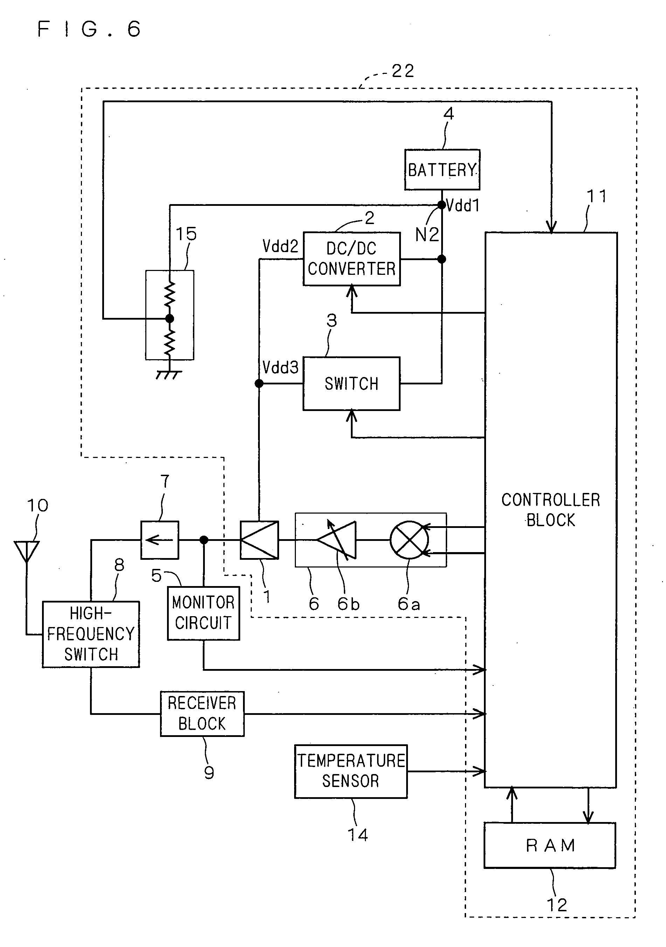

FIG. 6 is a block diagram showing the structure of a communication terminal device having a power amplifier device according to a second embodiment of the present invention.

As shown in the diagram, the operating power-supply voltage detecting circuit 13 of the first embodiment is replaced by an operating power-supply voltage detecting circuit 15, which detects the power-supply voltage Vdd1 at a node N2 from the battery 4 and provides the obtained detected power-supply voltage value VM to the controller block 11.

Accordingly, a power amplifier device 22 is formed by the HPA 1, DC/DC converter 2, switch 3, battery 4, transmitter block 6, controller block 11, RAM 12, and operating power-supply voltage detecting circuit 15. The portion of the power amplifier device 22 excluding the HPA 1, transmitter block 6, and operating power-supply voltage detecting circuit 15 functions as a power-supply voltage supplying portion. In other respects, the structure is the same as that of FIG. 1 of the first embodiment, and is not described again here.

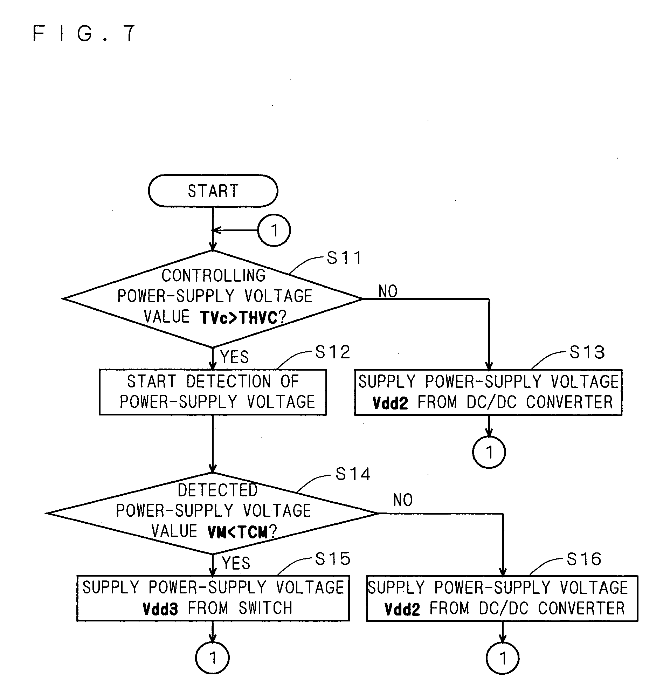

FIG. 7 is a flowchart of the operation of controlling the power-supply voltage supplied to the HPA 1 in the power amplifier device 22 of the communication terminal device of the second embodiment, which is performed under the control by the controller block 11. The procedure is described below referring to the diagram.

First, in step S11, as in the first embodiment, the value of the controlling power-supply voltage TVc to be given to the DC/DC converter 2 is compared with a given reference voltage THVC, and when TVc>THVC, the process judges that the HPA 1 is presenting high power output and moves to step S12. When not so, the process judges that the HPA 1 is presenting low power output and moves to step S 13.

In step S13, the DC/DC converter 2 is made active and the switch 3 is turned off to supply the power-supply voltage Vdd2 through the DC/DC converter 2. In this case, the DC/DC converter 2 is controlled such that the power-supply voltage Vdd2 agrees with the controlling power-supply voltage value TVc. After step S13, the flow returns to step S11. After that, the operations of steps S11 and S13 are repeated until TVc becomes larger than THVC (TVc>THVC).

In step S12, the operating power-supply voltage detecting circuit 15 starts detecting the power-supply voltage Vdd1 and obtains the detected power-supply voltage value VM.

In step S14, the detected power-supply voltage value VM(=Vdd1) is compared with a reference voltage TCM (TCL<TCM<TCH), and when VM<TCM, then the process judges that the power-supply voltage to the HPA 1 is too low and moves to step S15. If not so, the process judges that the power-supply voltage to the HPA 1 is sufficient and moves to step S16.

In step S15, the DC/DC converter 2 is made inactive and the switch 3 is turned on to supply the power-supply voltage Vdd3 from the switch 3. After step S15, the flow returns to step S11.

On the other hand, in step S 16, the power-supply voltage Vdd2 is supplied from the DC/DC converter 2 in the same way as in step S13. The flow moves to step S11 after step S16.

In this way, when VM(=Vdd1)<TCM, the power amplifier device of the second embodiment judges that the power-supply voltage Vdd3 is appropriate as the operating power-supply voltage to the HPA 1 and supplies the power-supply voltage Vdd3 through the switch 3. On the other hand, when VM(=Vdd1)≥TCM, it judges that the power-supply voltage Vdd2 is appropriate as the operating power-supply voltage of the HPA 1 and supplies the power-supply voltage Vdd2 through the DC/DC converter 2.

Thus, even when the HPA 1 is in a high power output period (the second period), the supply of the power-supply voltage Vdd2 from the DC/DC converter 2 is maintained as long as there is no problem for the operation of the HPA 1 (as long as VM≥VCM), which allows efficient operation of the HPA 1.

In this way, in the communication terminal device of the second embodiment, the power-supply voltage Vdd1 of the battery 4 is directly monitored, and so it is always possible to selectively control the supply of the power-supply voltage Vdd2 through the DC/DC converter 2 and the supply of the power-supply voltage Vdd3 through the switch 3 with the single reference voltage TCM.

In addition, because the second embodiment directly detects the power-supply voltage Vdd1 of the battery 4, it is possible to precisely make the selection shown in FIG. 4 between the DC/DC converter 2 and the switch 3 on the basis of the power-supply voltage Vdd1 of the battery 4.

Preferably, a switch that remains off except for during transmission is provided between the operating power-supply voltage detecting circuit 15 and the battery 4 in order to prevent current from flowing to the operating power-supply voltage detecting circuit 15 except for during transmission.

While the embodiments above have shown mobile communication terminal devices as an example, the invention is applicable also to, for example, wireless LAN systems that require the power amplifier devices 21, 22.

When the components in the power amplifier devices 21 and 22 are fabricated in the form of IC, the HPA 1, DC/DC converter 2, switch 3, and operating power-supply voltage detecting circuit 13 (the operating power-supply voltage detecting circuit 15), for example, can be fabricated as a single-chip IC.

## Claims

1. A power amplifier device comprising:
a power amplifier (1) that operates with an operating power-supply voltage obtained from a first power-supply voltage;
an operating power-supply voltage detecting circuit (13) that detects one of said operating power-supply voltage and said first power-supply voltage to obtain a detected power-supply voltage value; and
an operating power-supply voltage supplying portion (2, 3, 4, 11, 12) that has a power estimation function of estimating an output power value to be outputted from said power amplifier as an estimative output power value and that supplies said power amplifier with said operating power-supply voltage determined on the basis of said estimative output power value and said detected power-supply voltage value.

2. The power amplifier device according to claim 1, wherein said operating power-supply voltage supplying portion comprises:
a battery (4) that outputs said first power-supply voltage (Vdd1);
a power-supply voltage converting portion (2) that is interposed between said battery and said power amplifier and that converts said first power-supply voltage to a second power-supply voltage (Vdd2) that is lower than said first power-supply voltage;
a switch portion (3) that is interposed between said battery and said power amplifier in parallel with said power-supply voltage converting portion and that supplies said first power-supply voltage as a third power-supply voltage (Vdd3), said third power-supply voltage being higher than said second power-supply voltage; and
a controller block (11) that has functions of controlling operations of said power-supply voltage converting portion and said switch portion, and that judges on the basis of said estimative output power value whether said power amplifier is in a first period where said power amplifier performs a low power output operation or in a second period where said power amplifier performs a high power output operation, wherein, in said first period, said controller block supplies said second power-supply voltage obtained from said power-supply voltage converting portion as said operating power-supply voltage, and in said second period, said controller block supplies one of said second and third power-supply voltages as said operating power-supply voltage on the basis of said detected power-supply voltage value.

3. The power amplifier device according to claim 2, wherein
said operating power-supply voltage detecting circuit includes a circuit that detects said operating power-supply voltage,
and in said second period,
when said detected power-supply voltage value is below a first threshold while said second power-supply voltage is being supplied as said operating power-supply voltage, said controller block supplies said third power-supply voltage in place of said second power-supply voltage as said operating power-supply voltage, and
when said detected power-supply voltage value is above a second threshold higher than said first threshold while said third power-supply voltage is being supplied as said operating power-supply voltage, said controller block supplies said second power-supply voltage in place of said third power-supply voltage as said operating power-supply voltage.

4. The power amplifier device according to claim 2, wherein
said operating power-supply voltage detecting circuit comprises a circuit that detects said first power-supply voltage,
and in said second period,
when said detected power-supply voltage value is lower than a given threshold, said controller block supplies said third power-supply voltage as said operating power-supply voltage, and in other cases said controller block supplies said second power-supply voltage as said operating power-supply voltage.

5. The power amplifier device according to any of claims 2 to 4, wherein
said operating power-supply voltage supplying portion further comprises a storage (12) that stores a controlling power-supply voltage/power table (T12) that associates values of the output power of said power amplifier and values of a controlling power-supply voltage for said power amplifier,
and said controller block refers to said controlling power-supply voltage/power table in said storage to recognize said controlling power-supply voltage value corresponding to said estimative output power value, and judges whether said power amplifier is in said first period or said second period on the basis of a result of a comparison between said controlling power-supply voltage value and a given reference voltage.

6. A communication terminal device comprising:
a transmitter block (6) that generates a transmission signal;
a power amplifier (1) that is supplied with an operating power-supply voltage obtained from a first power-supply voltage outputted from a battery so as to operate to amplify transmission power of said transmission signal;
an operating power-supply voltage detecting circuit (13) that detects one of said operating power-supply voltage and said first power-supply voltage to obtain a detected power-supply voltage value; and
an operating power-supply voltage supplying portion (2, 3, 4, 11, 12) that controls said transmitter block and has a power estimation function of estimating an output power value to be outputted from said power amplifier as an estimative output power value, and that supplies said power amplifier with said operating power-supply voltage based on said estimative output power value and said detected power-supply voltage value.

7. The communication terminal device according to claim 6, wherein
said transmitter block comprises a variable gain amplifier (6b), and said output power value of said power amplifier is determined on the basis of a gain of said variable gain amplifier and a power amplification ratio of said power amplifier, and
said operating power-supply voltage supplying portion comprises a storage (12) that stores a gain controlling table (T12) that associates values of the output power of said power amplifier and values of a gain controlling voltage for said variable gain amplifier,
and said operating power-supply voltage supplying portion refers to said gain controlling table in said storage to recognize said gain controlling voltage value corresponding to said estimative output power value and performs a gain controlling operation to control the gain of said variable gain amplifier on the basis of the gain controlling voltage value.

8. The communication terminal device according to claim 7, further comprising:
a temperature sensor (14) that detects a device temperature of said communication terminal device, wherein
said operating power-supply voltage supplying portion refers to said gain controlling table in said storage and recognizes said gain controlling voltage value corresponding to said estimative output power value on the basis of a difference between said device temperature and a given reference device temperature.

9. The communication terminal device according to claim 7, further comprising:
a receiver block (9) that receives an external received signal, wherein
said operating power-supply voltage supplying portion is capable of recognizing a transmission frequency on the basis of an instruction defining the transmission frequency contained in said received signal, and said operating power-supply voltage supplying portion refers to said gain controlling table in said storage and recognizes said gain controlling voltage value corresponding to said estimative output power value on the basis of a difference between said transmission frequency and a given reference transmission frequency.

10. A method of controlling a power amplifier device having a power amplifier (1) that operates with an operating power-supply voltage obtained from a first power-supply voltage outputted from a battery, said method comprising the steps of:
(a) detecting one of said operating power-supply voltage and said first power-supply voltage to obtain a detected power-supply voltage value;
(b) estimating an output power value to be outputted from said power amplifier as an estimative output power value and judging whether said power amplifier performs a high power output operation or a low power output operation on the basis of said estimative output power value;
(c) when said step (b) judges that said power amplifier performs said low power output operation, supplying a voltage obtained by decreasing said first power-supply voltage as said operating power-supply voltage; and
(d) when said step (b) judges that said power amplifier performs said high power output operation, supplying, as said operating power-supply voltage, one of said first power-supply voltage and said voltage obtained by decreasing said first power-supply voltage, on the basis of said detected power-supply voltage value.
